# EUROPEAN PATENT SPECIFICATION

(11) **EP 3 993 035 B1**
(45) Date of publication and mention of the grant of the patent: **12.03.2025**
(21) Application number: 21201067.2
(22) Date of filing: 05.10.2021
(51) Int. Cl.: H01L 27/02, H02H 9/04

(54) **SEMICONDUCTOR CHIP WITH GATE OXIDE PROTECTION OF METAL-OXIDE-SEMICONDUCTOR TRANSISTOR AND/OR OXIDE PROTECTION OF METAL-OXIDE-METAL CAPACITOR**
HALBLEITERCHIP MIT GATE-OXIDSCHUTZ EINES METALLOXIDHALBLEITERTRANSISTORS UND/ODER OXIDSCHUTZ EINES METALLOXIDMETALLKONDENSATORS
PUCE SEMI-CONDUCTRICE AVEC PROTECTION PAR OXYDE DE GRILLE D'UN TRANSISTOR MÉTAL-OXYDE-SEMICONDUCTEUR ET/OU PROTECTION PAR OXYDE D'UN CONDENSATEUR MÉTAL-OXYDE-MÉTAL

(30) Priority: 27.10.2020 US 202063105924 P; 22.09.2021 US 202117481334
(43) Date of publication of application: 04.05.2022
(73) Proprietor: MEDIATEK Inc., Hsin-Chu 300 (TW)
(72) Inventor: CHEN, Pin-Wen, 30078 Hsinchu City (TW)
(74) Representative: Haseltine Lake Kempner LLP

(56) References cited:
- US-A- 5 343 352
- US-A1- 2014 362 482
- US-A1- 2020 105 661
- US-B1- 8 068 319
- US-B2- 7 463 466

## Description

This application claims the benefit of U.S. provisional application No. 63/105,924, filed on 10/27/2020.

### Background

The present invention relates to an integrated circuit design, and more particularly, to a semiconductor chip with gate oxide protection of a metal-oxide-semiconductor (MOS) transistor and/or oxide protection for a metal-oxide-metal (MOM) capacitor.

According to a complementary metal-oxide-semiconductor (CMOS) process, an N-channel MOS (NMOS) transistor is formed in a P well or P substrate connected to the ground voltage, and a P-channel MOS (PMOS) transistor is formed in an N well connected to the supply voltage. However, substrate noise currents may be a serious problem. One solution is to use an extra well - a 'deep N well'. For example, the deep N well (DNW) is formed by a high energy ion implantation to give peak impurity concentration deep enough without affecting the MOS transistor performance. Ideally, the deep N well has the effect of decreasing the noise coupling through it to the substrate and giving the advantage of fully isolated MOS transistors. However, during the CMOS manufacturing process, charges may be accumulated and trapped in wells before DNW devices are electrically connected via signal lines on metal layers. When two DNW devices are electrically connected via signal lines formed on the metal layer during the CMOS manufacturing process, charges accumulated in wells of the DNW devices may contribute to a high voltage at a gate terminal of a DNW device, and may damage the gate oxide of the DNW device. The DNW device may have degraded noise performance due to oxide defects. For example, an audio processing circuit using DNW devices with oxide defects may suffer from popcorn noise.

US 5 343 352 A describes a semiconductor integrated circuit employing a separate voltage supplying system in which a first circuit block is energized through a power supply line and a second circuit block is energized through another power supply line and provided with an improved protection circuit for the first circuit block.

US 8 068 319 B1 circuits, systems, and methods for protecting an integrated circuit having independently-powered circuit sections from electrostatic discharge events.

US 7 463 466 B2 describes an integrated circuit having an electrostatic discharge protection circuit therein.

US 2014/362482 A1 describes an ESD (Electrostatic discharge) structure for enhancing robustness of CDM (Charge Device Model).

### Summary

The invention is defined in the appended set of claims. One of the objectives of the claimed invention is to provide a semiconductor chip with gate oxide protection of a metal-oxide-semiconductor (MOS) transistor and/or oxide protection for a metal-oxide-metal (MOM) capacitor.

According to a first aspect of the present invention, an exemplary semiconductor chip is disclosed. The exemplary semiconductor chip includes a metal-oxide-semiconductor (MOS) transistor, a first oxide protection circuit, and a second oxide protection circuit. The first oxide protection circuit has a first terminal coupled to a gate terminal of the MOS transistor, and further has a second terminal arranged to receive a first ground voltage, wherein a noise level of the first ground voltage is lower than a noise level of a second ground voltage defined in the semiconductor chip. The second oxide protection circuit has a first terminal coupled to the gate terminal of the MOS transistor, and further has a second terminal arranged to receive a first supply voltage, wherein a noise level of the first supply voltage is lower than a noise level of a second supply voltage defined in the semiconductor chip, and an internal regulator circuit, arranged to regulate and output the first supply voltage according to the second supply voltage.

According to a second aspect of the present invention, an exemplary semiconductor chip is disclosed. The exemplary semiconductor chip includes a metal-oxide-metal (MOM) capacitor having a first plate and a second plate, a first oxide protection circuit, and a second oxide protection circuit. The first oxide protection circuit has a first terminal coupled to the first plate of the MOM capacitor, and further has a second terminal arranged to receive a first ground voltage, wherein a noise level of the first ground voltage is lower than a noise level of a second ground voltage defined in the semiconductor chip. The second oxide protection circuit has a first terminal coupled to the first plate of the MOM capacitor, and further has a second terminal arranged to receive a first supply voltage, wherein a noise level of the first supply voltage is lower than a noise level of a second supply voltage defined in the semiconductor chip, and an internal regulator circuit, arranged to regulate and output the first supply voltage according to the second supply voltage.

These and other objectives of the present invention will no doubt become obvious to those of ordinary skill in the art after reading the following detailed description of the preferred embodiment that is illustrated in the various figures and drawings.

### Brief Description of the Drawings

FIG. 1 is a diagram illustrating a first semiconductor chip with gate oxide protection of a metal-oxide-semiconductor transistor according to an embodiment of the present invention.
FIG. 2 is a section view of a portion of the semiconductor chip 100 according to an embodiment of the present invention.
FIG. 3 is a diagram illustrating a second semiconductor chip with gate oxide protection of a metal-oxide-semiconductor transistor according to an embodiment of the present invention.
FIG. 4 is a diagram illustrating a third semiconductor chip with gate oxide protection of a metal-oxide-semiconductor transistor according to an embodiment of the present invention.
FIG. 5 is a diagram illustrating a fourth semiconductor chip with gate oxide protection of a metal-oxide-semiconductor transistor according to an embodiment of the present invention.
FIG. 6 is a diagram illustrating a first semiconductor chip with gate oxide protection of a metal-oxide-semiconductor transistor and oxide protection of a metal-oxide-metal capacitor according to an embodiment of the present invention.
FIG. 7 is a diagram illustrating a second semiconductor chip with gate oxide protection of a metal-oxide-semiconductor transistor and oxide protection of a metal-oxide-metal capacitor according to an embodiment of the present invention.
FIG. 8 is a diagram illustrating a third semiconductor chip with gate oxide protection of a metal-oxide-semiconductor transistor and oxide protection of a metal-oxide-metal capacitor according to an embodiment of the present invention.
FIG. 9 is a diagram illustrating a fifth semiconductor chip with gate oxide protection of a metal-oxide-semiconductor transistor according to an embodiment of the present invention.
FIG. 10 is a diagram illustrating a sixth semiconductor chip with gate oxide protection of a metal-oxide-semiconductor transistor according to an embodiment of the present invention.
FIG. 11 is a diagram illustrating a fourth semiconductor chip with gate oxide protection of a metal-oxide-semiconductor transistor and oxide protection of a metal-oxide-metal capacitor according to an embodiment of the present invention.
FIG. 12 is a diagram illustrating a fifth semiconductor chip with gate oxide protection of a metal-oxide-semiconductor transistor and oxide protection of a metal-oxide-metal capacitor according to an embodiment of the present invention.

### Detailed Description

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

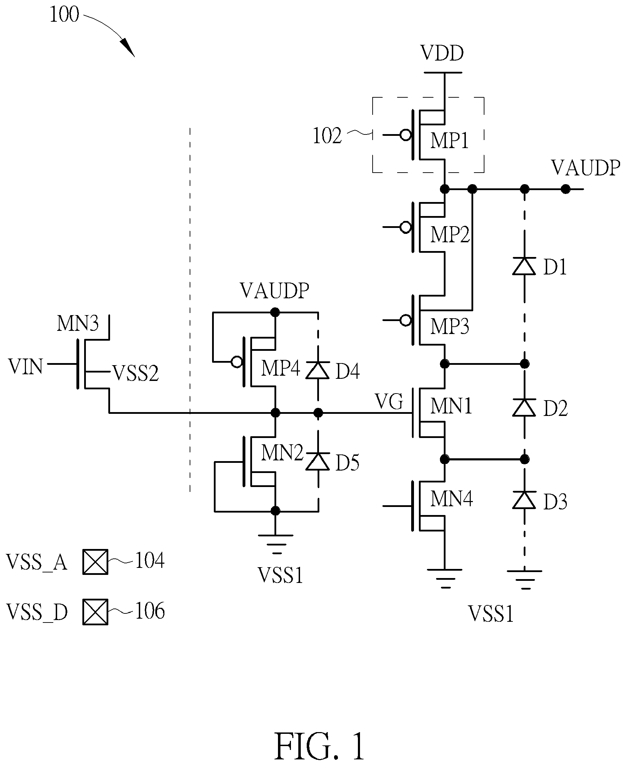

FIG. 1 is a diagram illustrating a first semiconductor chip with gate oxide protection of a metal-oxide-semiconductor transistor according to an embodiment of the present invention. The semiconductor chip 100 includes a plurality of N-channel metal-oxide-semiconductor (NMOS) transistors MN1, MN2, MN3, MN4 and a plurality of P-channel metal-oxide-semiconductor (PMOS) transistors MP1, MP2, MP3, MP4. In this embodiment, PMOS transistors MP1, MP2, MP3, MP4 and NMOS transistors MN2, MN3, MN4 are input/output (I/O) devices, and NMOS transistor MN1 is a core device. A gate oxide thickness of an I/O device is thicker than a gate oxide thickness of a core device. Compared to the core device with thin gate oxide, the I/O device with thick gate oxide can tolerate higher operation voltage. Compared to the I/O device with thick gate oxide, the core device with thin gate oxide can have lower noise.

By way of example, but not limitation, the NMOS transistor MN3 may be defined in one intellectual property (IP) core, and the NMOS transistors MN1, MN2, MN4 and the PMOS transistors MP1, MP2, MP3, MP4 may be defined in another IP core. It should be noted that only the components pertinent to the present invention are shown in FIG. 1. In practice, the semiconductor chip 100 can have additional components to achieve designated functions.

A gate terminal of the NMOS transistor MN3 is arranged to receive a voltage input V_{IN}, and a voltage at a source terminal of the NMOS transistor MN3 is arranged to set a gate voltage V_{G} at a gate terminal of the NMOS transistor MN1. For example, the semiconductor chip 100 includes an audio processing circuit (e.g., audio amplifier), and the NMOS transistor MN1 with gate oxide protection is a part of the audio processing circuit.

The PMOS transistor MP4 and the NMOS transistor MN2 are arranged to provide gate oxide protection for the NMOS transistor MN1. In this embodiment, the PMOS transistor MP4 is a gate-powered P-channel MOS (GPPMOS) transistor, having a drain terminal coupled to the gate terminal of the NMOS transistor MN1, and a gate terminal and a source terminal both arranged to receive a supply voltage VAUDP; and the NMOS transistor MN2 is a gate-grounded N-channel MOS (GGNMOS) transistor, having a drain terminal coupled to the gate terminal of the NMOS transistor MN1, and a gate terminal and a source terminal both arranged to receive a ground voltage VSS1.

To meet low-noise requirements of an application (e.g., audio application), each of NMOS transistors MN1, MN2 is a deep N-well (DNW) device, the ground voltage VSS1 is a clean ground, and the supply voltage VAUDP is a clean power. In this embodiment, the PMOS transistor MP1 serves as an internal low-dropout (LDO) regulator circuit 102 that is arranged to regulate and output the supply voltage VAUDP according to another supply voltage VDD, such that a noise level of the supply voltage (which is clean power) VAUDP is lower than a noise level of the supply voltage (which is dirty power) VDD defined in the semiconductor chip 200.

In addition, the semiconductor chip 200 has a ground pin 104 from which analog circuit(s) in the semiconductor chip 200 obtain an analog-domain ground voltage VSS_A, and further has a ground pin 106 from which digital circuit(s) in the semiconductor chip 200 obtain a digital-domain ground voltage VSS_D. Due to inherent characteristics of analog circuits and digital circuits, a noise level of the analog-domain ground voltage VSS_A is lower than a noise level of the digital-domain ground voltage VSS_D defined in the semiconductor chip 100. In this embodiment, the ground voltage VSS1 may be set by the analog-domain ground voltage (which is clean ground) VSS_A provided from the ground pin 104, and the ground voltage VSS2 coupled to a body terminal of the NMOS transistor MN3 may be set by the analog-domain ground voltage (which is clean ground) VSS_A provided from the ground pin 104 or the digital-domain ground voltage (which is dirty ground) VSS_D provided from the ground pin 106.

In practice, an NMOS transistor may have a body terminal that is coupled to a source terminal or grounded, depending upon actual design considerations. As a consequence of the MOS structure, a body diode is formed by the PN junction between a source terminal and a drain terminal if a body terminal is coupled to the source terminal. Hence, the body diode is also called a parasitic diode or an internal diode. The performance of the body diode is one important parameter of the MOS transistor, and is important when using the MOS transistor in an application. As shown in FIG. 1, a body diode D1 exists between a body terminal and a drain terminal of the PMOS transistor MP3, a body diode D2 exists between a drain terminal and a source terminal of the NMOS transistor MN1, a body diode D3 exists between a drain terminal and a source terminal of the NMOS transistor MN4, a body diode D4 exists between a source terminal and a drain terminal of the PMOS transistor MP4, and a body diode D5 exists between a source terminal and a drain terminal of the NMOS transistor MN2.

When the gate voltage V_{G} is low (V_{G} < VSS1), the body diode D5 is at a forward-biased state, and therefore clamps the gate voltage V_{G} to the ground voltage (which is clean ground) VSS1. When the gate voltage V_{G} is high (V_{G} > VAUDP), the body diode D4 is at a forward-biased state for discharging the gate voltage V_{G} to the supply voltage (which is clean power) VAUDP, or the gate voltage V_{G} is discharged to the ground voltage (which is clean ground) VSS1 through reversed diode leakage. Since the gate voltage V_{G} is prevented from being too high or too low, the PMOS transistor MP4 and the NMOS transistor MN2 ensure that gate oxide breakdown of the NMOS transistor MN1 does not occur.

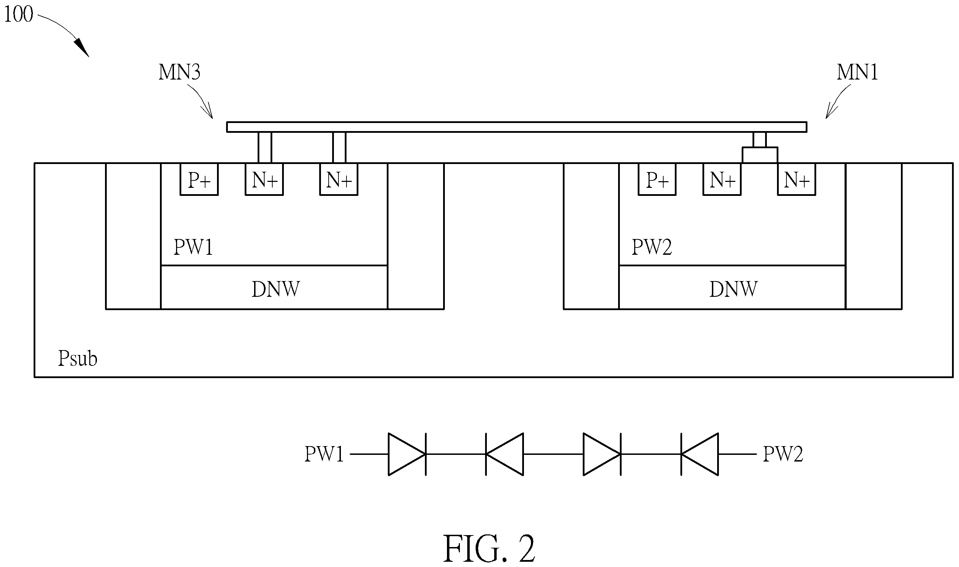

As mentioned above, during the CMOS manufacturing process, charges may be accumulated and trapped in wells before DNW devices are electrically connected via signal lines on metal layers. FIG. 2 is a section view of a portion of the semiconductor chip 100 according to an embodiment of the present invention. The NMOS transistor MN3 is formed on a P-well PW1, and a deep N-well (DNW) is formed between the P substrate Psub and the P-well PW1. The NMOS transistor MN1 is formed on a P-well PW2, and a deep N-well (DNW) is formed between the P substrate Psub and the P-well PW2. There are two reversed diodes and two forward diodes between P-wells PW1 and PW2. Since there are two reversed diodes, the breakdown voltage of PW1 and PW2 is too high, which is a cause of a high voltage at the gate terminal of the NMOS transistor MN1 during the CMOS manufacturing process under a conventional design. More specifically, a voltage applied to a gate terminal of a DNW device due to charges accumulated in wells of two DNW devices may be as high as the breakdown voltage decided by two reversed diodes. To address this issue, the present invention proposes gate oxide protection that uses a GPPMOS transistor between the clean power and the gate terminal of the NMOS transistor MN1 and a GGNMOS transistor between the gate terminal of the NMOS transistor MN1 and the clean ground.

As shown in FIG. 1, there are one forward diode D4 and one reversed diode D1 between the gate terminal and the drain terminal of the NMOS transistor MN1, there are one forward diode D3 and one reversed diode D5 between the gate terminal and the source terminal of the NMOS transistor MN1, and there are one forward diode D3 and one reversed diode D5 between the gate terminal and the body terminal of the NMOS transistor MN1. Since the number of reversed diodes between the gate terminal and the drain terminal of the NMOS transistor MN1 is smaller than two, the number of reversed diodes between the gate terminal and the source terminal of the NMOS transistor MN1 is smaller than two, and the number of reversed diodes between the gate terminal and the body terminal of the NMOS transistor MN1 is smaller than two, the gate oxide breakdown problem can be prevented during the CMOS manufacturing process. More specifically, during the CMOS manufacturing process, charges are accumulated and trapped in two DNW devices (e.g., NMOS transistors MN1 and MN3, each having one isolated P-well) before a signal line is formed on a metal layer above the P substrate to connect a drain terminal of one DNW device and a gate terminal of the other DNW device; and when the signal line is formed on the metal layer during the CMOS manufacturing process, it connects not only the DNW devices (e.g., NMOS transistors MN1 and MN3, each having one isolated P-well), but also drain terminals of a GGNMOS transistor (e.g., NMOS transistor MN2 that is a DNW device and functions as a diode) and a GPPMOS transistor (e.g., PMOS transistor MP4 that is a DNW device and functions as a diode).

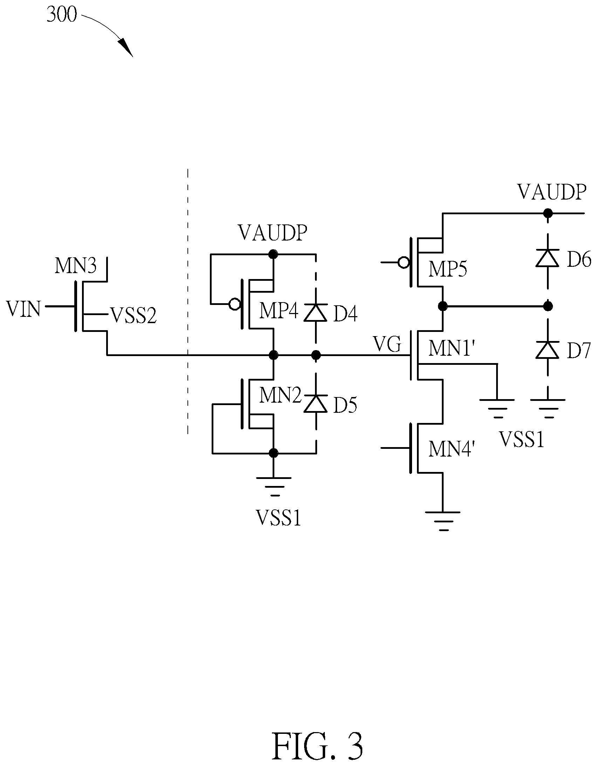

In the embodiment shown in FIG. 1, a core device with gate oxide protected by GGNMOS transistor and GPPMOS transistor is an NMOS transistor with a body terminal coupled to a source terminal. However, this is for illustrative purposes only, and is not meant to be a limitation of the present invention. FIG. 3 is a diagram illustrating a second semiconductor chip with gate oxide protection of a metal-oxide-semiconductor transistor according to an embodiment of the present invention. The semiconductor chip 300 includes a plurality of NMOS transistors MN1', MN2, MN3, MN4' and a plurality of PMOS transistors MP4, MP5. By way of example, but not limitation, the NMOS transistor MN3 may be defined in one IP core, and the NMOS transistors MN1', MN2, MN4' and the PMOS transistors MP4, MP5 may be defined in another IP core. In this embodiments, PMOS transistors MP4, MP5 and NMOS transistors MN2, MN3, MN4' are I/O devices with thick gate oxide, and NMOS transistor MN1' is a core device with thin gate oxide. To meet low-noise requirements of an application (e.g., audio application), each of NMOS transistors MN1', MN2 is a deep N-well (DNW) device.

A source terminal of the NMOS transistor MN1' is coupled to a drain terminal of the NMOS transistor MN4', and a body terminal of the NMOS transistor MN1' is arranged to receive the ground voltage (which is clean ground) VSS1. As shown in FIG. 3, a body diode D6 exists between a drain terminal and a source terminal of the PMOS transistor MP5, a body diode D7 exists between a body terminal and a drain terminal of the NMOS transistor MN1', a body diode D4 exists between a source terminal and a drain terminal of the PMOS transistor MP4, and a body diode D5 exists between a source terminal and a drain terminal of the NMOS transistor MN2. Since the body terminal of the NMOS transistor MN1' is arranged to receive the ground voltage VSS1, there is one reversed diode between the gate terminal and the body terminal of the NMOS transistor MN1'.

As a person skilled in the art can readily understand details of the core device gate oxide protection design shown in FIG. 3 after reading above paragraphs directed to the core device gate oxide protection design shown in FIG. 1, further description is omitted here for brevity.

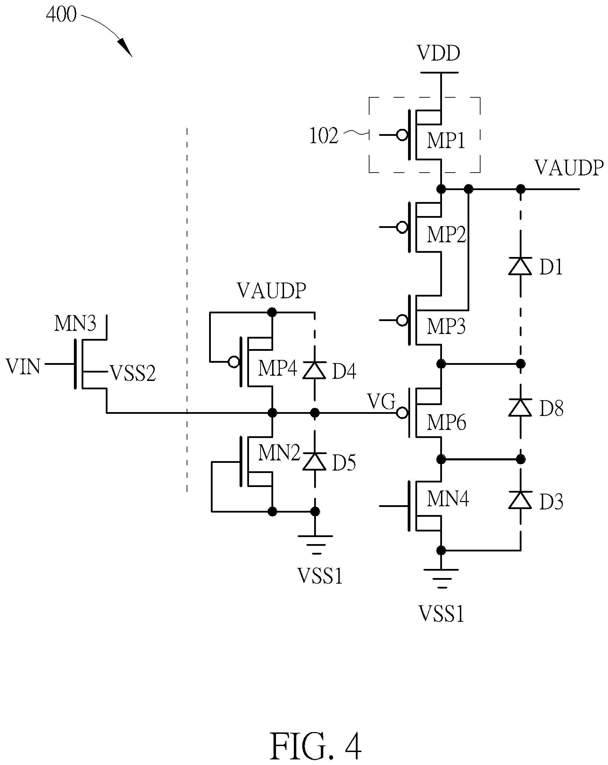

In the embodiment shown in FIG. 1, a core device with gate oxide protected by GGNMOS transistor and GPPMOS transistor is an NMOS transistor. The same gate oxide protection scheme can be applied to a core device being a PMOS transistor. FIG. 4 is a diagram illustrating a third semiconductor chip with gate oxide protection of a metal-oxide-semiconductor transistor according to an embodiment of the present invention. The semiconductor chip 400 includes a plurality of NMOS transistors MN2, MN3, MN4 and a plurality of PMOS transistors MP1, MP2, MP3, MP4, MP6. By way of example, but not limitation, the NMOS transistor MN3 may be defined in one IP core, and the NMOS transistors MN2, MN4 and the PMOS transistors MP1, MP2, MP3, MP4, MP6 may be defined in another IP core. In this embodiment, PMOS transistors MP1, MP2, MP3, MP4 and NMOS transistors MN2, MN3, MN4 are I/O devices with thick gate oxide, and PMOS transistor MP6 is a core device with thin gate oxide. The major difference between the semiconductor chips 100 and 400 is that a core device with gate oxide protected by GGNMOS transistor and GPPMOS transistor is the PMOS transistor MP6. Regarding the PMOS transistor MP6, a body diode D8 exists between a drain terminal and a source terminal.

When the gate voltage V_{G} is low (V_{G} < VSS1), the body diode D5 is at a forward-biased state, and therefore clamps the gate voltage V_{G} to the ground voltage VSS1 (which is clean ground that may be set by an analog-domain ground voltage used by analog circuit (s)). When the gate voltage V_{G} is high (V_{G} > VAUDP), the body diode D4 is at a forward-biased state for discharging the gate voltage V_{G} to the supply voltage VAUDP (which is clean power that may be provided from the internal LDO regulator circuit 102), or the gate voltage V_{G} is discharged to the ground voltage (which is clean ground) VSS1 through reversed diode leakage. Since the gate voltage V_{G} is prevented from being too high or too low, the PMOS transistor MP4 and the NMOS transistor MN2 ensure that gate oxide breakdown of the PMOS transistor MP6 does not occur.

As shown in FIG. 4, there are one forward diode D4 and one reversed diode D1 between the gate terminal and the source terminal of the PMOS transistor MP6, there are one forward diode D3 and one reversed diode D5 between the gate terminal and the drain terminal of the PMOS transistor MP6, and there are one forward diode D4 and one reversed diode D1 between the gate terminal and the body terminal of the PMOS transistor MP6. Since the number of reversed diodes between the gate terminal and the drain terminal of the PMOS transistor MP6 is smaller than two, the number of reversed diodes between the gate terminal and the source terminal of the PMOS transistor MP6 is smaller than two, and the number of reversed diodes between the gate terminal and the body terminal of the PMOS transistor MP6 is smaller than two, the gate oxide breakdown problem can be presented during the CMOS manufacturing process.

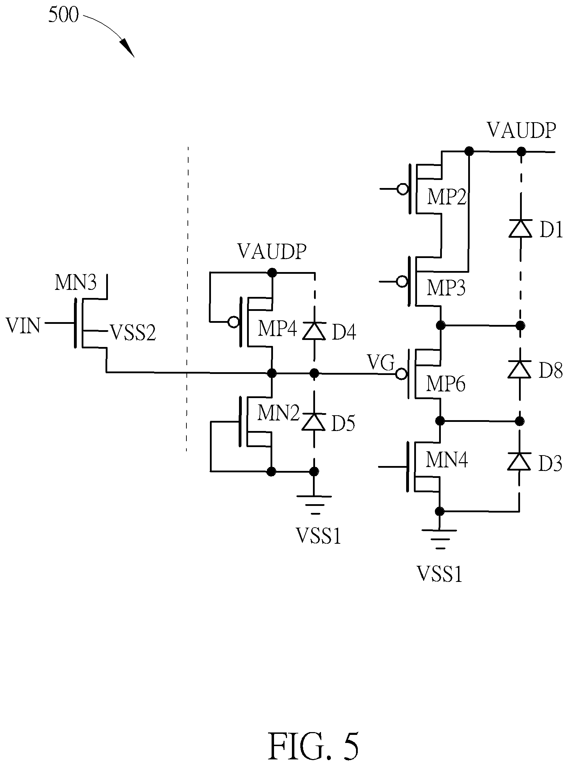

The circuit design shown in FIG. 4 is for illustrative purposes only, and is not meant to be a limitation of the present invention. In practice, any circuit design having the proposed core device gate oxide protection scheme with GGNMOS transistor and GPPMOS transistor falls within the scope of the present invention. FIG. 5 is a diagram illustrating a fourth semiconductor chip with gate oxide protection of a metal-oxide-semiconductor transistor according to an embodiment of the present invention. As a person skilled in the art can readily understand details of the core device gate oxide protection design employed by the semiconductor chip 500 shown in FIG. 5 after reading above paragraphs directed to the core device gate oxide protection design shown in FIG. 4, similar description is omitted here for brevity.

In above embodiments, the PMOS transistor MP4 and the NMOS transistor MN2 are used to provide gate oxide protection for a core device. In some embodiments, the PMOS transistor MP4 and the NMOS transistor MN2 may be used to provide oxide protection for a metal-oxide-metal (MOM) capacitor.

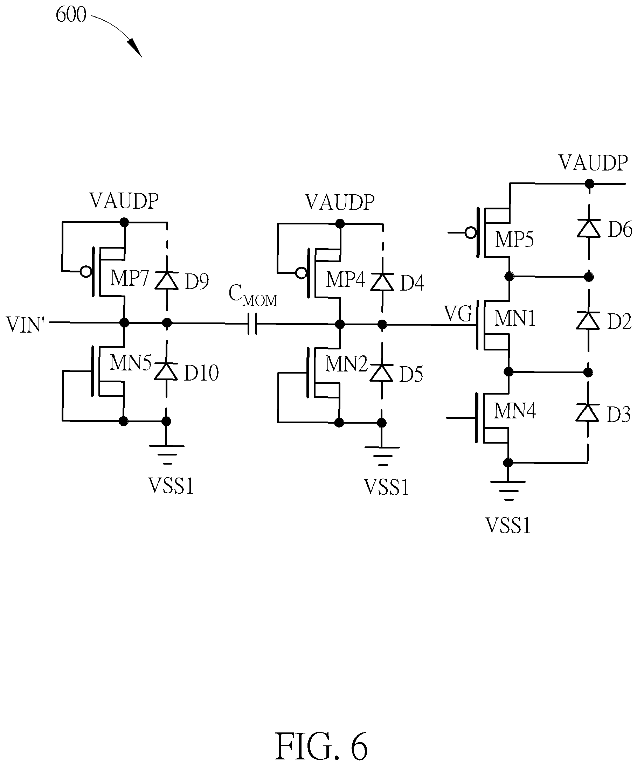

FIG. 6 is a diagram illustrating a first semiconductor chip with gate oxide protection of a metal-oxide-semiconductor transistor and oxide protection of a metal-oxide-metal capacitor according to an embodiment of the present invention. The semiconductor chip 600 includes a plurality of NMOS transistors MN1, MN2, MN4, MN5, a plurality of PMOS transistors MP4, MP5, MP7, and an MOM capacitor C_{MOM}. In this embodiment, PMOS transistors MP4, MP5, MP7 and NMOS transistors MN2, MN4, MN5 are I/O devices, and NMOS transistor MN1 is a core device. The MOM capacitor C_{MOM} may act as an alternating current (AC) coupling capacitor for passing an AC component of a voltage input V_{IN}' to set a gate voltage V_{G} at a gate terminal of the NMOS transistor MN1. For example, the semiconductor chip 600 includes an audio processing circuit (e.g., audio amplifier), and each of the MOM capacitor C_{MOM} and the NMOS transistor MN1 is a part of the audio processing circuit. To meet low-noise requirements of an application (e.g., audio application), each of NMOS transistors MN1, MN2, MN5 is a deep N-well (DNW) device.

In this embodiment, each of PMOS transistors MP4, MP7 is a GPPMOS transistor, and each of NMOS transistors MN2, MN5 is a GNNMOS transistor. Regarding the PMOS transistor MP4, it has a drain terminal coupled to the gate terminal of the NMOS transistor MN1 and also coupled to one plate of the MOM capacitor C_{MOM}, and a gate terminal and a source terminal both arranged to receive the supply voltage VAUDP (which is clean power that may be provided from a voltage regulator circuit). Regarding the NMOS transistor MN2, it has a drain terminal coupled to the gate terminal of the NMOS transistor MN1 and also coupled to one plate of the MOM capacitor C_{MOM}, and a gate terminal and a source terminal both arranged to receive the ground voltage VSS1 (which is clean ground that may be set by an analog-domain ground voltage used by analog circuit(s)). Regarding the PMOS transistor MP7, it has a drain terminal coupled to the voltage input V_{IN}' and also coupled to the other plate of the MOM capacitor C_{MOM} , and a gate terminal and a source terminal both arranged to receive the supply voltage VAUDP. Regarding the NMOS transistor MN5, it has a drain terminal coupled to the voltage input V_{IN}' and also coupled to the other plate of the MOM capacitor C_{MOM}, and a gate terminal and a source terminal both arranged to receive the ground voltage VSS1. As shown in FIG. 6, a body diode D9 exists between the drain terminal and the source terminal of the PMOS transistor MP7, and a body diode D10 exists between the source terminal and the drain terminal of the NMOS transistor MN5.

Like these embodiments mentioned above, this embodiment can use the PMOS transistor MP4 and the NMOS transistor MN2 to provide gate oxide protection for the NMOS transistor MN1. In addition, since one plate of the MOM capacitor C_{MOM} is coupled to drain terminals of PMOS transistor MP4 and NMOS transistor MN2, this embodiment can use the PMOS transistor MP4 and the NMOS transistor MN2 to provide oxide protection for the MOM capacitor C_{MOM}. For example, when a voltage of one plate of the MOM capacitor C_{MOM} is lower than VSS1, the body diode D5 is at a forward-biased state, and therefore clamps the voltage of one plate of the C_{MOM} to the ground voltage (which is clean ground) VSS1. For another example, when the voltage of one plate of the MOM capacitor C_{MOM} is higher than VAUDP, the body diode D4 is at a forward-biased state for discharging the voltage of one plate of the MOM capacitor C_{MOM} to the supply voltage (which is clean power) VAUDP, or the voltage of one plate of the MOM capacitor C_{MOM} is discharged to the ground voltage (which is clean ground) VSS1 through reversed diode leakage.

Similarly, since the other plate of the MOM capacitor C_{MOM} is coupled to drain terminals of PMOS transistor MP7 and NMOS transistor MN5, this embodiment can also use the PMOS transistor MP7 and the NMOS transistor MN5 to provide oxide protection for the MOM capacitor C_{MOM}. For example, when a voltage of the other plate of the MOM capacitor C_{MOM} is lower than VSS1, the body diode D10 is at a forward-biased state, and therefore clamps the voltage of the other plate of the C_{MOM} to the ground voltage (which is clean ground) VSS1. For another example, when the voltage of the other plate of the MOM capacitor C_{MOM} is higher than VAUDP, the body diode D9 is at a forward-biased state for discharging the voltage of the other plate of the MOM capacitor C_{MOM} to the supply voltage (which is clean power) VAUDP, or the voltage of the other plate of the MOM capacitor C_{MOM} is discharged to the ground voltage (which is clean ground) VSS1 through reversed diode leakage.

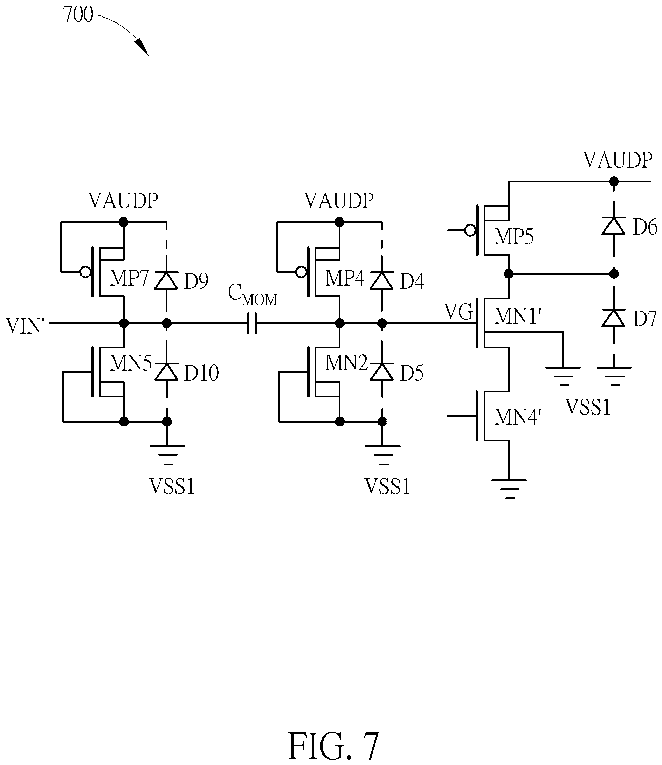

In the embodiment shown in FIG. 6, a core device with gate oxide protected by GGNMOS transistor and GPPMOS transistor is an NMOS transistor with a body terminal coupled to a source terminal. However, this is for illustrative purposes only, and is not meant to be a limitation of the present invention. FIG. 7 is a diagram illustrating a second semiconductor chip with gate oxide protection of a metal-oxide-semiconductor transistor and oxide protection of a metal-oxide-metal capacitor according to an embodiment of the present invention. The semiconductor chip 700 includes a plurality of NMOS transistors MN1', MN2, MN4', MN5, a plurality of PMOS transistors MP4, MP5, MP7, and an MOM capacitor C_{MOM}. In this embodiment, PMOS transistors MP4, MP5, MP7 and NMOS transistors MN2, MN4', MN5 are I/O devices with thick gate oxide, and NMOS transistor MN1' is a core device with thin gate oxide. To meet low-noise requirements of an application (e.g., audio application), each of NMOS transistors MN1', MN2, MN5 is a deep N-well (DNW) device.

A source terminal of the NMOS transistor MN1' is coupled to a drain terminal of the NMOS transistor MN4', and a body terminal of the NMOS transistor MN1' is arranged to receive the ground voltage VSS1 (which is clean ground that may be set by an analog-domain ground voltage) . As a person skilled in the art can readily understand details of the core device gate oxide protection design and the capacitor oxide protection design shown in FIG. 7 after reading above paragraphs directed to the core device gate oxide protection design and the capacitor oxide protection design shown in FIG. 6, further description is omitted here for brevity.

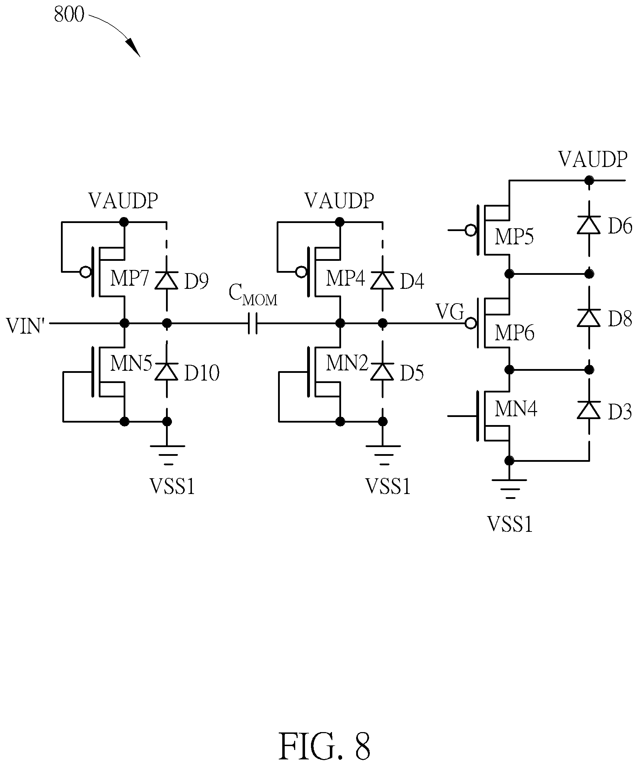

In the embodiment shown in FIG. 6, a core device with gate oxide protected by GGNMOS transistor and GPPMOS transistor is an NMOS transistor. The same gate oxide protection scheme can be applied to a core device being a PMOS transistor. FIG. 8 is a diagram illustrating a third semiconductor chip with gate oxide protection of a metal-oxide-semiconductor transistor and oxide protection of a metal-oxide-metal capacitor according to an embodiment of the present invention. The semiconductor chip 800 includes a plurality of NMOS transistors MN2, MN4, MN5, a plurality of PMOS transistors MP4, MP5, MP6, MP7, and an MOM capacitor C_{MOM}. In this embodiment, PMOS transistors MP4, MP5, MP7 and NMOS transistors MN2, MN4, MN5 are I/O devices with thick gate oxide, and PMOS transistor MP6 is a core device with thin gate oxide. The major difference between the semiconductor chips 600 and 800 is that a core device with gate oxide protected by GGNMOS transistor and GPPMOS transistor is the PMOS transistor MP6. As a person skilled in the art can readily understand details of the core device gate oxide protection design and the capacitor oxide protection design shown in FIG. 8 after reading above paragraphs directed to the core device gate oxide protection design and the capacitor oxide protection design shown in FIG. 6, further description is omitted here for brevity.

In above embodiments, one oxide protection circuit (e.g., NMOS transistor MN2/MN5), having a first terminal (e.g., drain terminal) coupled to the gate terminal of a core device (or one plate of an MOM capacitor) and further having a second terminal (e.g., joint terminal consisting of gate terminal and source terminal coupled to each other) arranged to receive the ground voltage (which is clean ground) VSS1, is implemented using an I/O device; and another oxide protection circuit (e.g., PMOS transistor MP4/MP7), having a first terminal (e.g., drain terminal) coupled to the gate terminal of the core device (or one plate of the MOM capacitor) and further having a second terminal (e.g., joint terminal consisting of gate terminal and source terminal coupled to each other) arranged to receive the supply voltage (which is clean power) VAUDP, is implemented using an I/O device. However, these are for illustrative purposes only, and are not meant to be limitations of the present invention. In one alternative design, an oxide protection circuit may be implemented using a core device. In another alternative design, an oxide protection circuit may be implemented using a diode (which is not a body diode of one MOS transistor). To put it simply, an oxide protection circuit in a semiconductor chip may include a core device, an I/O device, or a diode, depending upon actual design considerations. Hence, oxide protection circuits in the same semiconductor chip may include core device(s), I/O device(s), diode(s), or a combination thereof.

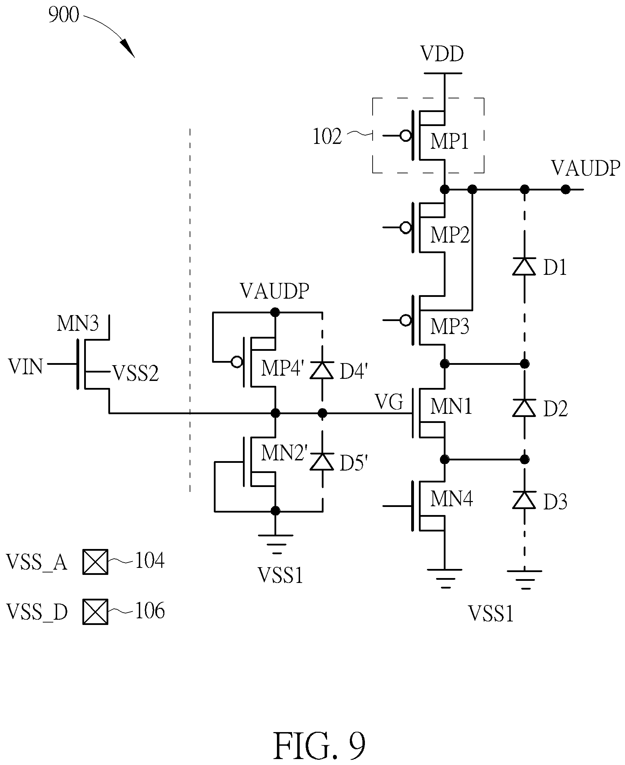

FIG. 9 is a diagram illustrating a fifth semiconductor chip with gate oxide protection of a metal-oxide-semiconductor transistor according to an embodiment of the present invention. The major difference between the semiconductor chips 900 and 100 is that the semiconductor chip 900 employs core devices as oxide protection circuits. Specifically, one oxide protection circuit (e.g., NMOS transistor MN2' with body diode D5'), having a first terminal (e.g., drain terminal) coupled to the gate terminal of the NMOS transistor MN1 and further having a second terminal (e.g., joint terminal consisting of gate terminal and source terminal coupled to each other) arranged to receive the ground voltage (which is clean ground) VSS1, is implemented using a core device the same as the NMOS transistor MN1, such that NMOS transistors MN1 and MN2' may have the same oxide layer thickness; and another oxide protection circuit (e.g., PMOS transistor MP4' with body diode D4'), having a first terminal (e.g., drain terminal) coupled to the gate terminal of the NMOS transistor MN1 and further having a second terminal (e.g., gate terminal and source terminal coupled to each other) arranged to receive the supply voltage (which is clean power) VAUDP, is implemented using a core device the same as the NMOS transistor MN1, such that NMOS transistor MN1 and PMOS transistor MP4' may have the same oxide layer thickness.

Similarly, the semiconductor chips 300-500 shown in FIGs. 3-5 may be modified to employ core devices as oxide protection circuits. Further description is omitted here for brevity.

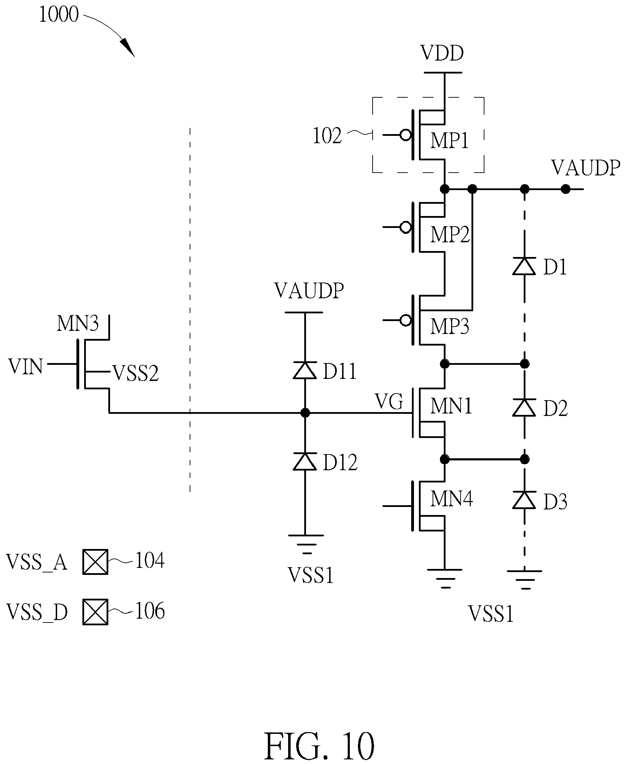

FIG. 10 is a diagram illustrating a sixth semiconductor chip with gate oxide protection of a metal-oxide-semiconductor transistor according to an embodiment of the present invention. The major difference between the semiconductor chips 1000 and 100 is that the semiconductor chip 1000 employs diodes (which are not body diodes of MOS transistors) as oxide protection circuits. Specifically, one oxide protection circuit (e.g., diode D12) has a first terminal (e.g., cathode) coupled to the gate terminal of the NMOS transistor MN1 and further has a second terminal (e.g., anode) arranged to receive the ground voltage (which is clean ground) VSS1; and another oxide protection circuit (e.g., diode D11) has a first terminal (e.g., anode) coupled to the gate terminal of the NMOS transistor MN1 and further has a second terminal (e.g., cathode) arranged to receive the supply voltage (which is clean power) VAUDP.

Similarly, the semiconductor chips 300-500 shown in FIGs. 3-5 may be modified to employ diodes as oxide protection circuits. Further description is omitted here for brevity.

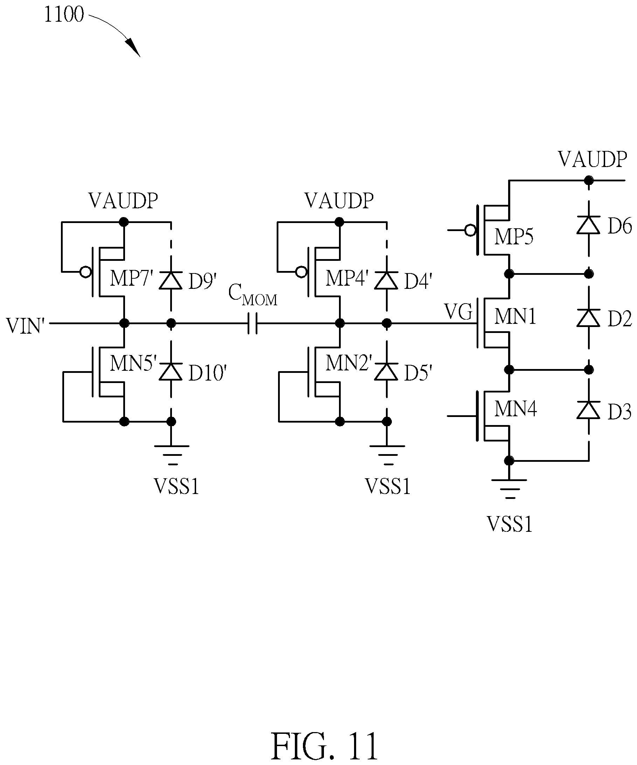

FIG. 11 is a diagram illustrating a fourth semiconductor chip with gate oxide protection of a metal-oxide-semiconductor transistor and oxide protection of a metal-oxide-metal capacitor according to an embodiment of the present invention. The major difference between the semiconductor chips 1100 and 600 is that the semiconductor chip 1100 employs core devices as oxide protection circuits. Specifically, a first oxide protection circuit (e.g., NMOS transistor MN2' with body diode D5'), having a first terminal (e.g., drain terminal) coupled to the gate terminal of the NMOS transistor MN1 and one plate of the MOM capacitor C_{MOM} and further having a second terminal (e.g., joint terminal consisting of gate terminal and source terminal coupled to each other) arranged to receive the ground voltage (which is clean ground) VSS1, is implemented using a core device the same as the NMOS transistor MN1, such that NMOS transistors MN1 and MN2' may have the same oxide layer thickness; a second oxide protection circuit (e.g., PMOS transistor MP4' with body diode D4'), having a first terminal (e.g., drain terminal) coupled to one plate of the MOM capacitor C_{MOM} and the gate terminal of the NMOS transistor MN1 and further having a second terminal (e.g., joint terminal consisting of gate terminal and source terminal coupled to each other) arranged to receive the supply voltage (which is clean power) VAUDP, is implemented using a core device the same as the NMOS transistor MN1, such that NMOS transistor MN1 and PMOS transistor MP4' may have the same oxide layer thickness; a third oxide protection circuit (e.g., NMOS transistor MN5' with body diode D10'), having a first terminal (e.g., drain terminal) coupled to the other plate of the MOM capacitor C_{MOM} and further having a second terminal (e.g., joint terminal consisting of gate terminal and source terminal coupled to each other) arranged to receive the ground voltage (which is clean ground) VSS1, is implemented using a core device the same as the NMOS transistor MN1, such that NMOS transistors MN1 and MN5' may have the same oxide layer thickness; and a fourth oxide protection circuit (e.g., PMOS transistor MP7' with body diode D9'), having a first terminal (e.g., drain terminal) coupled to the other plate of the MOM capacitor C_{MOM} and further having a second terminal (e.g., joint terminal consisting of gate terminal and source terminal coupled to each other) arranged to receive the supply voltage (which is clean power) VAUDP, is implemented using a core device the same as the NMOS transistor MN1, such that NMOS transistor MN1 and PMOS transistor MP7' may have the same oxide layer thickness.

Similarly, the semiconductor chips 700-800 shown in FIGs. 7-8 may be modified to employ core devices as oxide protection circuits. Further description is omitted here for brevity.

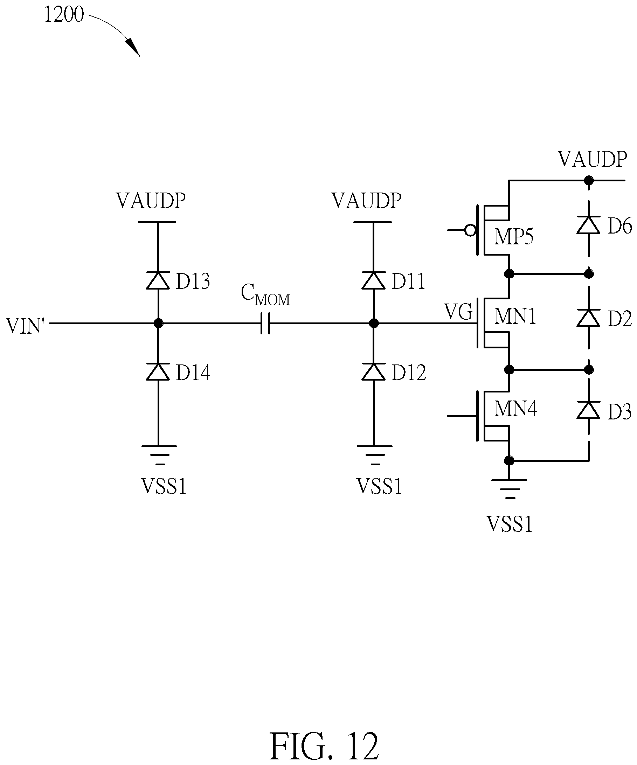

FIG. 12 is a diagram illustrating a fifth semiconductor chip with gate oxide protection of a metal-oxide-semiconductor transistor and oxide protection of a metal-oxide-metal capacitor according to an embodiment of the present invention. The major difference between the semiconductor chips 1200 and 600 is that the semiconductor chip 1200 employs diodes (which are not body diodes of MOS transistors) as oxide protection circuits. Specifically, a first oxide protection circuit (e.g., diode D12) has a first terminal (e.g., cathode) coupled to one plate of the MOM capacitor C_{MOM} and the gate terminal of the NMOS transistor MN1, and further has a second terminal (e.g., anode) arranged to receive the ground voltage (which is clean ground) VSS1; a second oxide protection circuit (e.g., diode D11) has a first terminal (e.g., anode) coupled to one plate of the MOM capacitor C_{MOM} and the gate terminal of the NMOS transistor MN1, and further has a second terminal (e.g., cathode) arranged to receive the supply voltage (which is clean power) VAUDP; a third oxide protection circuit (e.g., diode D14) has a first terminal (e.g., cathode) coupled to the other plate of the MOM capacitor C_{MOM}, and further has a second terminal (e.g., anode) arranged to receive the ground voltage (which is clean ground) VSS1; and a fourth oxide protection circuit (e.g., diode D13) has a first terminal (e.g., anode) coupled to the other plate of the MOM capacitor C_{MOM}, and further has a second terminal (e.g., cathode) arranged to receive the supply voltage (which is clean power) VAUDP.

Similarly, the semiconductor chips 700-800 shown in FIGs. 7-8 may be modified to employ diodes as oxide protection circuits. Further description is omitted here for brevity.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A semiconductor chip (100, 200, 300, 400) comprising:
a metal-oxide-semiconductor, MOS, transistor, having a gate terminal;
a first oxide protection circuit, having a first terminal coupled to the gate terminal of the MOS transistor, and further having a second terminal arranged to receive a first ground voltage, wherein a noise level of the first ground voltage is lower than a noise level of a second ground voltage defined in the semiconductor chip (100, 200, 300, 400);
a second oxide protection circuit, having a first terminal coupled to the gate terminal of the MOS transistor, and further having a second terminal arranged to receive a first supply voltage, wherein a noise level of the first supply voltage is lower than a noise level of a second supply voltage defined in the semiconductor chip (100, 200, 300, 400);
**characterized in that** the chip (100, 200, 300, 400) comprises an internal regulator circuit, arranged to regulate and output the first supply voltage according to the second supply voltage.

2. The semiconductor chip (100, 200, 300, 400) of claim 1, wherein the first oxide protection circuit comprises:
a diode, having a cathode acting as the first terminal of the first oxide protection component, and further having an anode acting as the second terminal of the first oxide protection component; or
wherein the second oxide protection circuit comprises:
a diode, having an anode acting as the first terminal of the second oxide protection component, and further having a cathode acting as the second terminal of the second oxide protection component.

3. The semiconductor chip (100, 200, 300, 400) of claim 1, wherein the first oxide protection circuit comprises:
a gate-grounded N-channel MOS, GGNMOS, transistor, having a drain terminal acting as the first terminal of the first oxide protection circuit, and further having a gate terminal and a source terminal both acting as the second terminal of the first oxide protection circuit.

4. The semiconductor chip (100, 200, 300, 400) of claim 3, wherein a gate oxide thickness of the MOS transistor is thinner than a gate oxide thickness of the GGNMOS transistor; or
wherein a gate oxide thickness of the MOS transistor is equal to a gate oxide thickness of the GGNMOS transistor; or
wherein each of the MOS transistor and the GGNMOS transistor is a deep N-well, DNW, device.

5. The semiconductor chip (100, 200, 300, 400) of claim 1, wherein the second oxide protection circuit comprises:
a gate-powered P-channel MOS, GPPMOS, transistor, having a drain terminal acting as the first terminal of the second oxide protection circuit, and further having a gate terminal and a source terminal both acting as the second terminal of the second oxide protection circuit.

6. The semiconductor chip (100, 200, 300, 400) of claim 5, wherein a gate oxide thickness of the MOS transistor is thinner than a gate oxide thickness of the GPPMOS transistor; or
wherein a gate oxide thickness of the MOS transistor is equal to a gate oxide thickness of the GPPMOS transistor.

7. The semiconductor chip (100, 200, 300, 400) of claim 1, further comprising:
a metal-oxide-metal, MOM, capacitor, having a first plate coupled to the gate terminal of the MOS transistor.

8. The semiconductor chip (100, 200, 300, 400) of claim 7, further comprising:
a third oxide protection circuit, having a first terminal coupled to a second plate of the MOM capacitor, and further having a second terminal arranged to receive the first ground voltage; and
a fourth oxide protection circuit, having a first terminal coupled to the second plate of the MOM capacitor, and further having a second terminal arranged to receive the first supply voltage.

9. A semiconductor chip (100, 200, 300, 400) comprising:
a metal-oxide-metal, MOM, capacitor, having a first plate and a second plate;
a first oxide protection circuit, having a first terminal coupled to the first plate of the MOM capacitor, and further having a second terminal arranged to receive a first ground voltage, wherein a noise level of the first ground voltage is lower than a noise level of a second ground voltage defined in the semiconductor chip;
a second oxide protection circuit, having a first terminal coupled to the first plate of the MOM capacitor, and further having a second terminal arranged to receive a first supply voltage, wherein a noise level of the first supply voltage is lower than a noise level of a second supply voltage defined in the semiconductor chip (100, 200, 300, 400);
**characterized in that** the chip (100, 200, 300, 400) comprises an internal regulator circuit, arranged to regulate and output the first supply voltage according to the second supply voltage.

10. The semiconductor chip (100, 200, 300, 400) of claim 9, wherein the first oxide protection circuit comprises:
a diode, having a cathode acting as the first terminal of the first oxide protection component, and further having an anode acting as the second terminal of the first oxide protection component; or
wherein the second oxide protection circuit comprises:
a diode, having an anode acting as the first terminal of the second oxide protection component, and further having a cathode acting as the second terminal of the second oxide protection component.

11. The semiconductor chip (100, 200, 300, 400) of claim 9, wherein the first oxide protection circuit comprises:
a gate-grounded N-channel MOS, GGNMOS, transistor, having a drain terminal acting as the first terminal of the first oxide protection circuit, and further having a gate terminal and a source terminal both acting as the second terminal of the first oxide protection circuit.

12. The semiconductor chip (100, 200, 300, 400) of claim 11, wherein a gate oxide thickness of the MOS transistor is thinner than a gate oxide thickness of the GGNMOS transistor; or
wherein a gate oxide thickness of the MOS transistor is equal to a gate oxide thickness of the GGNMOS transistor; or
wherein each of the MOS transistor and the GGNMOS transistor is a deep N-well, DNW, device.

13. The semiconductor chip (100, 200, 300, 400) of claim 9, wherein the second oxide protection circuit comprises:
a gate-powered P-channel MOS, GPPMOS, transistor, having a drain terminal acting as the first terminal of the second oxide protection circuit, and further having a gate terminal and a source terminal both acting as the second terminal of the second oxide protection circuit.

14. The semiconductor chip (100, 200, 300, 400) of claim 13, wherein a gate oxide thickness of the MOS transistor is thinner than a gate oxide thickness of the GPPMOS transistor; or
wherein a gate oxide thickness of the MOS transistor is equal to a gate oxide thickness of the GPPMOS transistor.

15. The semiconductor chip (100, 200, 300, 400) of claim 9, further comprising:
a third oxide protection circuit, having a first terminal coupled to the second plate of the MOM capacitor, and further having a second terminal arranged to receive the first ground voltage; and
a fourth oxide protection circuit, having a first terminal coupled to the second plate of the MOM capacitor, and further having a second terminal arranged to receive the first supply voltage.

## Patentansprüche

1. Halbleiterchip (100, 200, 300, 400), umfassend:
einen Metalloxidhalbleitertransistor, MOS-Transistor, mit einem Gateanschluss;
eine erste Oxidschutzschaltung mit einem ersten Anschluss, der mit dem Gateanschluss des MOS-Transistors gekoppelt ist, und ferner mit einem zweiten Anschluss, der dazu ausgelegt ist, eine erste Erdspannung zu empfangen, wobei ein Rauschpegel der ersten Erdspannung niedriger ist als ein Rauschpegel einer zweiten Erdspannung, die in dem Halbleiterchip (100, 200, 300, 400) definiert ist;
eine zweite Oxidschutzschaltung mit einem ersten Anschluss, der mit dem Gateanschluss des MOS-Transistors gekoppelt ist, und ferner mit einem zweiten Anschluss, der dazu ausgelegt ist, eine erste Versorgungsspannung zu empfangen, wobei ein Rauschpegel der ersten Versorgungsspannung niedriger ist als ein Rauschpegel einer zweiten Versorgungsspannung, die in dem Halbleiterchip (100, 200, 300, 400) definiert ist;
**dadurch gekennzeichnet, dass** der Chip (100, 200, 300, 400) eine interne Regelschaltung umfasst, die dazu ausgelegt ist, die erste Versorgungsspannung gemäß der zweiten Versorgungsspannung zu regeln und auszugeben.

2. Halbleiterchip (100, 200, 300, 400) nach Anspruch 1, wobei die erste Oxidschutzschaltung Folgendes umfasst:
eine Diode mit einer Kathode, die als der erste Anschluss der ersten Oxidschutzkomponente fungiert, und ferner mit einer Anode, die als der zweite Anschluss der ersten Oxidschutzkomponente fungiert; oder
wobei die zweite Oxidschutzschaltung Folgendes umfasst:
eine Diode mit einer Anode, die als der erste Anschluss der zweiten Oxidschutzkomponente fungiert, und ferner mit einer Kathode, die als der zweite Anschluss der zweiten Oxidschutzkomponente fungiert.

3. Halbleiterchip (100, 200, 300, 400) nach Anspruch 1, wobei die erste Oxidschutzschaltung Folgendes umfasst:
einen Gate-geerdeten N-Kanal-MOS-Transistor, GGNMOS-Transistor, mit einem Drainanschluss, der als der erste Anschluss der ersten Oxidschutzschaltung fungiert, und ferner mit einem Gateanschluss und einem Sourceanschluss, die beide als der zweite Anschluss der ersten Oxidschutzschaltung fungieren.

4. Halbleiterchip (100, 200, 300, 400) nach Anspruch 3, wobei eine Gate-Oxiddicke des MOS-Transistors dünner ist als eine Gate-Oxiddicke des GGNMOS-Transistors; oder
wobei eine Gate-Oxiddicke des MOS-Transistors gleich einer Gate-Oxiddicke des GGNMOS-Transistors ist; oder
wobei jeder von dem MOS-Transistor und dem GGNMOS-Transistor eine Vorrichtung mit einer tiefen N-Wanne, DNW, ist.

5. Halbleiterchip (100, 200, 300, 400) nach Anspruch 1, wobei die zweite Oxidschutzschaltung Folgendes umfasst:
einen Gate-gespeisten P-Kanal-MOS-Transistor, GPPMOS-Transistor, mit einem Drainanschluss, der als der erste Anschluss der zweiten Oxidschutzschaltung fungiert, und ferner mit einem Gateanschluss und einem Sourceanschluss, die beide als der zweite Anschluss der zweiten Oxidschutzschaltung fungieren.

6. Halbleiterchip (100, 200, 300, 400) nach Anspruch 5, wobei eine Gate-Oxiddicke des MOS-Transistors dünner ist als eine Gate-Oxiddicke des GPPMOS-Transistors; oder
wobei eine Gate-Oxiddicke des MOS-Transistors gleich einer Gate-Oxiddicke des GPPMOS-Transistors ist.

7. Halbleiterchip (100, 200, 300, 400) nach Anspruch 1, ferner umfassend:
einen Metalloxidmetallkondensator, MOM-Kondensator, mit einer ersten Platte, die mit dem Gateanschluss des MOS-Transistors gekoppelt ist.

8. Halbleiterchip (100, 200, 300, 400) nach Anspruch 7, ferner umfassend:
eine dritte Oxidschutzschaltung mit einem ersten Anschluss, der mit einer zweiten Platte des MOM-Kondensators gekoppelt ist, und ferner mit einem zweiten Anschluss, der dazu ausgelegt ist, die erste Erdspannung zu empfangen; und
eine vierte Oxidschutzschaltung mit einem ersten Anschluss, der mit der zweiten Platte des MOM-Kondensators gekoppelt ist, und ferner mit einem zweiten Anschluss, der dazu ausgelegt ist, die erste Versorgungsspannung zu empfangen.

9. Halbleiterchip (100, 200, 300, 400), umfassend:
einen Metalloxidmetallkondensator, MOM-Kondensator, mit einer ersten Platte und einer zweiten Platte;
eine erste Oxidschutzschaltung mit einem ersten Anschluss, der mit der ersten Platte des MOM-Kondensators gekoppelt ist, und ferner mit einem zweiten Anschluss, der dazu ausgelegt ist, eine erste Erdspannung zu empfangen, wobei ein Rauschpegel der ersten Erdspannung niedriger ist als ein Rauschpegel einer zweiten Erdspannung, die in dem Halbleiterchip definiert ist;
eine zweite Oxidschutzschaltung mit einem ersten Anschluss, der mit der ersten Platte des MOM-Kondensators gekoppelt ist, und ferner mit einem zweiten Anschluss, der dazu ausgelegt ist, eine erste Versorgungsspannung zu empfangen, wobei ein Rauschpegel der ersten Versorgungsspannung niedriger ist als ein Rauschpegel einer zweiten Versorgungsspannung, die in dem Halbleiterchip (100, 200, 300, 400) definiert ist;
**dadurch gekennzeichnet, dass** der Chip (100, 200, 300, 400) eine interne Regelschaltung umfasst, die dazu ausgelegt ist, die erste Versorgungsspannung gemäß der zweiten Versorgungsspannung zu regeln und auszugeben.

10. Halbleiterchip (100, 200, 300, 400) nach Anspruch 9, wobei die erste Oxidschutzschaltung Folgendes umfasst:
eine Diode mit einer Kathode, die als der erste Anschluss der ersten Oxidschutzkomponente fungiert, und ferner mit einer Anode, die als der zweite Anschluss der ersten Oxidschutzkomponente fungiert; oder
wobei die zweite Oxidschutzschaltung Folgendes umfasst:
eine Diode mit einer Anode, die als der erste Anschluss der zweiten Oxidschutzkomponente fungiert, und ferner mit einer Kathode, die als der zweite Anschluss der zweiten Oxidschutzkomponente fungiert.

11. Halbleiterchip (100, 200, 300, 400) nach Anspruch 9, wobei die erste Oxidschutzschaltung Folgendes umfasst:
einen Gate-geerdeten N-Kanal-MOS-Transistor, GGNMOS-Transistor, mit einem Drain-Anschluss, der als der erste Anschluss der ersten Oxidschutzschaltung fungiert, und ferner mit einem Gateanschluss und einem Sourceanschluss, die beide als der zweite Anschluss der ersten Oxidschutzschaltung fungieren.

12. Halbleiterchip (100, 200, 300, 400) nach Anspruch 11, wobei eine Gate-Oxiddicke des MOS-Transistors dünner ist als eine Gate-Oxiddicke des GGNMOS-Transistors; oder
wobei eine Gate-Oxiddicke des MOS-Transistors gleich einer Gate-Oxiddicke des GGNMOS-Transistors ist; oder
wobei jeder von dem MOS-Transistor und dem GGNMOS-Transistor eine Vorrichtung mit einer tiefen N-Wanne, DNW, ist.

13. Halbleiterchip (100, 200, 300, 400) nach Anspruch 9, wobei die zweite Oxidschutzschaltung Folgendes umfasst:
einen Gate-gespeisten P-Kanal-MOS-Transistor, GPPMOS-Transistor, mit einem Drainanschluss, der als der erste Anschluss der zweiten Oxidschutzschaltung fungiert, und ferner mit einem Gateanschluss und einem Sourceanschluss, die beide als der zweite Anschluss der zweiten Oxidschutzschaltung fungieren.

14. Halbleiterchip (100, 200, 300, 400) nach Anspruch 13, wobei eine Gate-Oxiddicke des MOS-Transistors dünner ist als eine Gate-Oxiddicke des GPPMOS-Transistors; oder
wobei eine Gate-Oxiddicke des MOS-Transistors gleich einer Gate-Oxiddicke des GPPMOS-Transistors ist.

15. Halbleiterchip (100, 200, 300, 400) nach Anspruch 9, ferner umfassend:
eine dritte Oxidschutzschaltung mit einem ersten Anschluss, der mit der zweiten Platte des MOM-Kondensators gekoppelt ist, und ferner mit einem zweiten Anschluss, der dazu ausgelegt ist, die erste Erdspannung zu empfangen; und
eine vierte Oxidschutzschaltung mit einem ersten Anschluss, der mit der zweiten Platte des MOM-Kondensators gekoppelt ist, und ferner mit einem zweiten Anschluss, der dazu ausgelegt ist, die erste Versorgungsspannung zu empfangen.

## Revendications

1. Puce semi-conductrice (100, 200, 300, 400) comprenant :
un transistor métal-oxyde-semiconducteur, MOS, ayant une borne de grille ;
un premier circuit de protection par oxyde, ayant une première borne couplée à la borne de grille du transistor MOS, et ayant également une seconde borne agencée pour recevoir une première tension de masse, dans laquelle un niveau de bruit de la première tension de masse est inférieur à un niveau de bruit d'une seconde tension de masse définie dans la puce semi-conductrice (100, 200, 300, 400) ;
un deuxième circuit de protection par oxyde, ayant une première borne couplée à la borne de grille du transistor MOS, et ayant également une seconde borne agencée pour recevoir une première tension d'alimentation, dans laquelle un niveau de bruit de la première tension d'alimentation est inférieur à un niveau de bruit d'une seconde tension d'alimentation définie dans la puce semi-conductrice (100, 200, 300, 400) ;
**caractérisée en ce que** la puce (100, 200, 300, 400) comprend un circuit régulateur interne, agencé pour réguler et délivrer la première tension d'alimentation en fonction de la seconde tension d'alimentation.

2. Puce semi-conductrice (100, 200, 300, 400) selon la revendication 1, dans laquelle le premier circuit de protection par oxyde comprend :
une diode, ayant une cathode agissant comme première borne du premier composant de protection par oxyde, et ayant également une anode agissant comme seconde borne du premier composant de protection par oxyde ; ou
dans laquelle le deuxième circuit de protection par oxyde comprend :
une diode, ayant une anode agissant comme première borne du second composant de protection par oxyde, et ayant également une cathode agissant comme seconde borne du second composant de protection par oxyde.

3. Puce semi-conductrice (100, 200, 300, 400) selon la revendication 1, dans laquelle le premier circuit de protection par oxyde comprend :
un transistor MOS à canal N à grille mise à la terre, GGNMOS, ayant une borne de drain agissant comme première borne du premier circuit de protection par oxyde, et ayant également une borne de grille et une borne de source agissant toutes deux comme seconde borne du premier circuit de protection par oxyde.

4. Puce semi-conductrice (100, 200, 300, 400) selon la revendication 3, dans laquelle l'épaisseur d'oxyde de grille du transistor MOS est plus fine que l'épaisseur d'oxyde de grille du transistor GGNMOS ; ou
dans laquelle l'épaisseur d'oxyde de grille du transistor MOS est égale à l'épaisseur d'oxyde de grille du transistor GGNMOS ; ou
dans laquelle chacun du transistor MOS et du transistor GGNMOS est un dispositif à puits N profond, DNW.

5. Puce semi-conductrice (100, 200, 300, 400) selon la revendication 1, dans laquelle le deuxième circuit de protection par oxyde comprend :
un transistor MOS à canal P à grille alimentée, GPPMOS, ayant une borne de drain agissant comme première borne du deuxième circuit de protection par oxyde, et ayant également une borne de grille et une borne de source agissant toutes deux comme seconde borne du deuxième circuit de protection par oxyde.

6. Puce semi-conductrice (100, 200, 300, 400) selon la revendication 5, dans laquelle l'épaisseur d'oxyde de grille du transistor MOS est plus fine que l'épaisseur d'oxyde de grille du transistor GPPMOS ; ou
dans laquelle l'épaisseur d'oxyde de grille du transistor MOS est égale à l'épaisseur d'oxyde de grille du transistor GPPMOS.

7. Puce semi-conductrice (100, 200, 300, 400) selon la revendication 1, comprenant également :
un condensateur métal-oxyde-métal, MOM, ayant une première plaque couplée à la borne de grille du transistor MOS.

8. Puce semi-conductrice (100, 200, 300, 400) selon la revendication 7, comprenant également :
un troisième circuit de protection par oxyde, ayant une première borne couplée à une seconde plaque du condensateur MOM, et ayant également une seconde borne agencée pour recevoir la première tension de masse ; et
un quatrième circuit de protection par oxyde, ayant une première borne couplée à la seconde plaque du condensateur MOM, et ayant également une seconde borne agencée pour recevoir la première tension d'alimentation.

9. Puce semi-conductrice (100, 200, 300, 400) comprenant :
un condensateur métal-oxyde-métal, MOM, ayant une première plaque et une seconde plaque ;
un premier circuit de protection par oxyde, ayant une première borne couplée à la première plaque du condensateur MOM, et ayant également une seconde borne agencée pour recevoir une première tension de masse, dans laquelle un niveau de bruit de la première tension de masse est inférieur à un niveau de bruit d'une seconde tension de masse définie dans la puce semi-conductrice ;
un deuxième circuit de protection par oxyde, ayant une première borne couplée à la première plaque du condensateur MOM, et ayant également une seconde borne agencée pour recevoir une première tension d'alimentation, dans laquelle un niveau de bruit de la première tension d'alimentation est inférieur à un niveau de bruit d'une seconde tension d'alimentation définie dans la puce semi-conductrice (100, 200, 300, 400) ;
**caractérisée en ce que** la puce (100, 200, 300, 400) comprend un circuit régulateur interne, agencé pour réguler et délivrer la première tension d'alimentation en fonction de la seconde tension d'alimentation.

10. Puce semi-conductrice (100, 200, 300, 400) selon la revendication 9, dans laquelle le premier circuit de protection par oxyde comprend :
une diode, ayant une cathode agissant comme première borne du premier composant de protection par oxyde, et ayant également une anode agissant comme seconde borne du premier composant de protection par oxyde ; ou
dans laquelle le deuxième circuit de protection par oxyde comprend :
une diode, ayant une anode agissant comme première borne du second composant de protection par oxyde, et ayant également une cathode agissant comme seconde borne du second composant de protection par oxyde.

11. Puce semi-conductrice (100, 200, 300, 400) selon la revendication 9, dans laquelle le premier circuit de protection par oxyde comprend :
un transistor MOS à canal N à grille mise à la terre, GGNMOS, ayant une borne de drain agissant comme première borne du premier circuit de protection par oxyde, et ayant également une borne de grille et une borne de source agissant toutes deux comme seconde borne du premier circuit de protection par oxyde.

12. Puce semi-conductrice (100, 200, 300, 400) selon la revendication 11, dans laquelle l'épaisseur d'oxyde de grille du transistor MOS est plus fine que l'épaisseur d'oxyde de grille du transistor GGNMOS ; ou
dans laquelle l'épaisseur d'oxyde de grille du transistor MOS est égale à l'épaisseur d'oxyde de grille du transistor GGNMOS ; ou
dans laquelle chacun du transistor MOS et du transistor GGNMOS est un dispositif à puits N profond, DNW.

13. Puce semi-conductrice (100, 200, 300, 400) selon la revendication 9, dans laquelle le deuxième circuit de protection par oxyde comprend :
un transistor MOS à canal P à grille alimentée, GPPMOS, ayant une borne de drain agissant comme première borne du deuxième circuit de protection par oxyde, et ayant également une borne de grille et une borne de source agissant toutes deux comme seconde borne du deuxième circuit de protection par oxyde.

14. Puce semi-conductrice (100, 200, 300, 400) selon la revendication 13, dans laquelle l'épaisseur d'oxyde de grille du transistor MOS est plus fine que l'épaisseur d'oxyde de grille du transistor GPPMOS ; ou
dans laquelle l'épaisseur d'oxyde de grille du transistor MOS est égale à l'épaisseur d'oxyde de grille du transistor GPPMOS.

15. Puce semi-conductrice (100, 200, 300, 400) selon la revendication 9, comprenant également :
un troisième circuit de protection par oxyde, ayant une première borne couplée à la seconde plaque du condensateur MOM, et ayant également une seconde borne agencée pour recevoir la première tension de masse ; et
un quatrième circuit de protection par oxyde, ayant une première borne couplée à la seconde plaque du condensateur MOM, et ayant également une seconde borne agencée pour recevoir la première tension d'alimentation.
